# EUROPEAN PATENT SPECIFICATION

(11) **EP 2 921 247 B1**
(45) Date of publication and mention of the grant of the patent: **09.05.2018**
(21) Application number: 15159671.5
(22) Date of filing: 18.03.2015
(51) Int. Cl.: B23K 3/06, B23K 3/02, B23K 3/08, B23K 3/03

(54) **INTEGRATED SOLDERING DEVICE**
INTEGRIERTE LÖTVORRICHTUNG
DISPOSITIF DE BRASAGE INTÉGRÉ

(30) Priority: 18.03.2014 US 201461954842 P; 28.01.2015 US 201514607300
(43) Date of publication of application: 23.09.2015
(73) Proprietor: Tektronix, Inc., Beaverton, Oregon 97077-0001 (US)
(72) Inventor: Cocklin, Thomas, Portland, Oregon 97213 (US); Tarr, Tony, Portland, Oregon 97211 (US); Romey, Samuel, Saint Paul, Oregon 97137 (US); Heltborg, Andy, Aloha, Oregon 97006 (US); Braunberger, Jason, Happy Valley, Oregon 97086 (US); Brown, Stephen, Vancouver, Washington 98686 (US); Klecker, Glenn, Silverton, Oregon 97381 (US); Carcia, Anthony, Portland, Oregon 97215 (US)
(74) Representative: HGF Limited

(56) References cited:
- CA-A- 916 247
- JP-A- H11 277 224
- JP-A- 2012 024 798
- JP-A- 2012 094 771
- US-A- 3 707 258
- US-A1- 2009 140 028
- US-B1- 6 369 359

## Description

### BACKGROUND OF THE INVENTION

The present disclosure relates to a hand-held soldering device and to a method of soldering with a hand-held soldering device according to the preamble of claims 1 and 15 respectively (see, for example, US3 707 258).

Often there is a need to test electronic equipment and components. To perform these tests, test leads are soldered, usually by hand, to pre-determined points to collect data. Depending on the complexity of the device or component, the number of test leads required may be few or many. There are other tasks, such as green-wire, re-soldering and de-soldering may also be done using this device.

As electronics and electronics packaging gets smaller and more complex, it is becoming more difficult and time consuming to wire test leads. The precision required for placement and the small field in which to operate makes it difficult for users using a traditional soldering iron and techniques to solder the test leads (or accomplish other tasks at this level). The users not only have to place and hold the wire and the soldering iron, but then solder the wire and hold the wire while it cures before cutting it to the proper length. This multi-step process is time consuming and taxing to the user.

There is a need for a new soldering device that integrates the many tools required for soldering, provides user flexibility for different soldering situations and assists the user with the task of soldering and placement.

US 6 369 359 relates to a self feeding soldering device including a soldering device; a solder feed mechanism carried on the soldering device; and a solder system controller in controlling connection with the soldering device and the solder feed mechanism.

JP 2012 024798 relates to a soldering iron smoke cleaning device.

JP H11 277224 relates to a soldering iron with integrated camera.

US 3 707 258 relates to a soldering gun for one-handed manipulation, including a soldering wire supply bobbin and means for feeding the bobbin.

US 2009/140028 relates to a soldering system for melting a solder to form a joint between a first workpiece and a second workpiece, comprising an energy generating system, a soldering tip, and a dispenser adapted to dispense controlled amounts of the solder.

### SUMMARY

There is provided a hand-held soldering device as set out in claim 1, and a method of soldering with a hand-held soldering device as set out in claim 15.

An integrated soldering device and method for using the same is disclosed. The soldering device comprises mechanisms to assist a user with soldering tasks. A wire feeder dispenses the test lead (or in another instance a soldering tip) and a heater heats the wire to melt the solder to create the solder joint. An air handling system clears fumes and smoke away from the solder field to further assist the user. The consumables, solder paste and wire, may be stored in cartridges on the device, allowing for the easy replacement. The hand-held device may also include a light, a camera with magnification, a cutter, and/or a solder joint cooling system.

### BRIEF DESCRIPTION OF THE DRAWINGS

FIG. 1 illustrates a soldering device according to the some embodiments of the invention.
FIG. 2A illustrates the wire feed mechanism of the device of FIG. 1 in a first position.
FIG. 2B illustrates the wire feed mechanism of the device of FIG. 1 in a second position.
FIG. 2C illustrates the wire feed mechanism of the device of FIG. 1 in a third position.
FIG. 3A illustrates an embodiment of the wire heater of the device of FIG. 1.
FIG. 3B illustrates another embodiment of the wire heater of the device of FIG. 1.
FIG. 4A illustrates the air handling system of the device of FIG. 1.
FIG. 4B illustrates the air recirculation system of the device of FIG. 1.
FIG. 5 illustrates an embodiment of the camera and light systems of the device of FIG. 1.
FIG. 6A illustrates an embodiment of the solder dispenser of the device of FIG. 1.
FIG. 6B illustrates another embodiment of the solder dispenser of the device of FIG. 1.
FIG. 6C illustrates a further embodiment of the solder dispenser of the device of FIG. 1.

### DETAILED DESCRIPTION

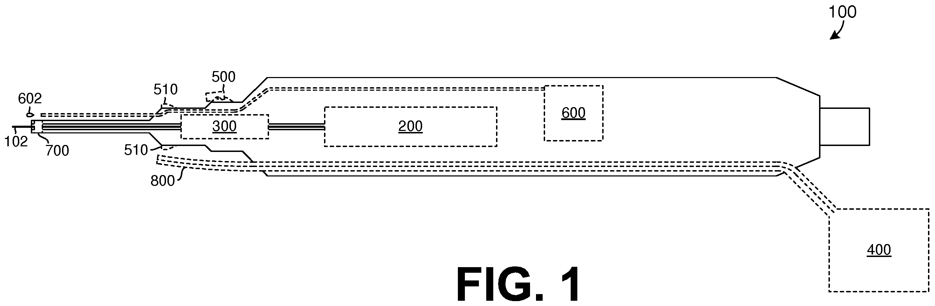

FIG. 1 illustrates a soldering device 100 that may include the following features: a wire feed mechanism 200 to advance the wire 102 through the device, a wire heater 300, an air handling system 400, a camera 500, lights 510, a solder dispensing system 600, a wire cutter 700, and a solder joint cooling system 800, each of which will be discussed in more detail below.

The soldering device 100 assists a user with soldering a wire 102 to a desired location (or soldering without the wire). The solder paste 602 may be dispensed from the device 100 by the solder dispensing system 600. However, the user may also manually provide solder paste to the wire 102 tip. According to the present invention, the tip of the wire 102 is heated, by the wire heater 300, to act as a soldering iron. The hot wire 102 is then placed in the solder paste 602, melting the paste to create the solder joint. The hot joint is cooled and solidified by the cooling system 800. The desired length of wire 102 is dispensed from the device by the wire feed mechanism 200 and cut to length either manually or by the wire cutter 700.

An air handling system 400 evacuates fumes from the soldering joint to protect a user's health and a clear view of the soldering field.

The camera 500 and lights 510 assist the user with wire 102 placement. The camera 500 provides a magnified view to a display, allowing the user to more closely see the surface for soldering and thus assisting with greater accuracy in placing the wire 102 and soldering joint. The lights 510 may be used in conjunction with the camera 500, or alone, to light the field.

### WIRE FEED MECHANISM

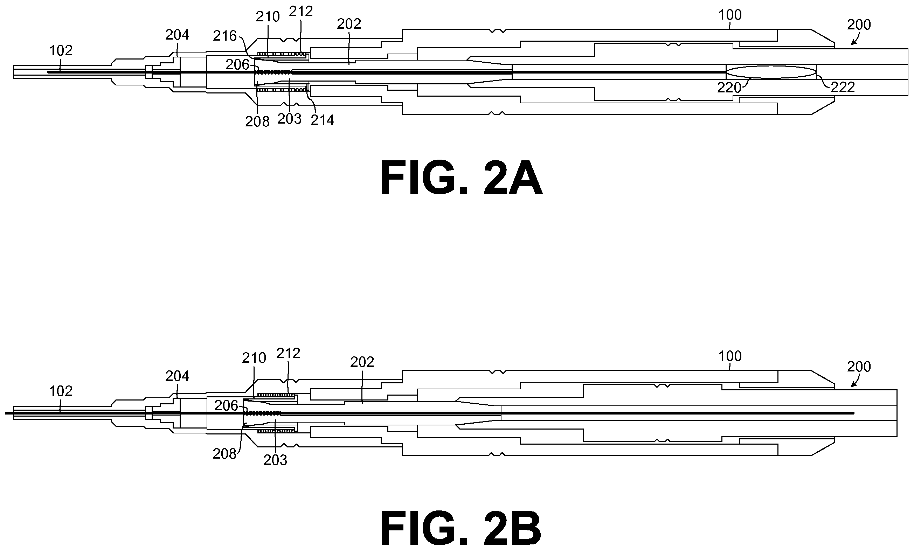

FIG. 2A shows the wire feed mechanism 200 used to advance the wire 102 from the device 100. The mechanism 200 may consist of a three-jaw chuck 202, a sleeve 210, a sleeve spring 212, and a rubber brake 204.

The three-jaw chuck 202 includes three jaws that extend from a central shaft. Each jaw 203 has teeth 206 on an interior side that grip the wire 102 and a flared protrusion 208 on an exterior side. Compression about the exterior circumference of the three jaws 203 of the chuck 202 causes the teeth 206 of each jaw 203 to engage or "pinch" the wire 102.

A rubber brake 204 is disposed inside the device 100 near the base of the mechanism 200. The brake 204 blocks the travel of the chuck 202 as it advances. Additionally, the brake 204 grips and retains the wire 102 using friction. The friction prevents the wire 102 from slipping through the mechanism 200 when the chuck 202 is not gripping the wire 102. The advancement of the chuck 202 exerts a force on the wire 102 that is sufficient to overcome the frictional force of the brake 204, allowing the wire 102 to advance from the device 100.

The sleeve 210 has a first diameter 214 and a second diameter 216, which is larger than the first diameter 214. The transition of the sleeve 210 from the first diameter 214 to the second diameter 216 follows the contour of the protrusion 208 of the three-jaw chuck 202. A sleeve spring 212 is disposed between the exterior of the sleeve 210 and the interior of the mechanism 200 housing.

In a first position of the mechanism, as shown in FIG. 2A, the sleeve and the three-jaw chuck 202 are engaged. The second diameter 216 of the sleeve 210 compresses the jaws 203 of the three-jaw chuck 202 about the wire 102. The compression of the jaws 203 about the wire 102 prevents the wire from traveling through the device. As the three-jaw chuck 202 and the sleeve 210 travel to a second position, or are "plunged," the sleeve 210 and chuck 202 continue to be engaged and advance the wire 102. At the second position, as shown in FIG. 2B, the sleeve spring 212 is completely compressed preventing additional forward travel of the sleeve 210. At this position, the three-jaw chuck 202 continues to be driven forward. As the three-jaw chuck 202 travels forward past the sleeve 210, the protrusions 208 disengage from the second diameter 216 of the sleeve 210. The disengagement of the protrusions 208 causes the jaws 203 of the three-jaw chuck 202 to expand and the teeth 206 to disengage from the wire 102. At this point of disengagement, the advancement of the wire 102 is a negligible or zero amount. Free from the engagement with the protrusions 208, the sleeve 210 is driven back to a first position by the decompression of the sleeve spring 212.

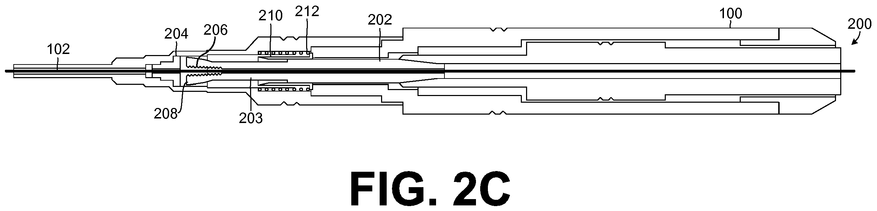

The three-jaw chuck 202 continues to move forward until it reaches the limit of travel at a third position, as shown in FIG. 2C, at or near the brake 204. The driving force on the three-jaw chuck 202 disengages and the chuck 202 retracts back to the first position. As the jaws of the chuck return to the first position, the protrusions 208 engage with the sleeve 210. The engagement of the protrusions 208 and the sleeve 210 causes the jaws 203 to be compressed inward and grip the wire 102.

In an embodiment the three-jaw chuck 202 can be stopped at the third position allowing the wire 102 to be dispensed freely by pulling it from the mechanism 200.

The length of wire advanced with each cycle of the mechanism 200 is determined by the distance traveled by the sleeve between the first and the second positions. The distance traveled by the sleeve may be varied by the user by using a different length sleeve and spring set. This allows a user to select the length of wire advanced by each compression of the spring sleeve 210 and three-jaw chuck 202.

Alternatively, a stop, may be inserted between the spring 212 and the sleeve 210 (not shown). The stop shortens the travel length of the sleeve 210 between the first and second position, thus changing the length of the wire 102 dispensed.

In a further embodiment of the mechanism 200 (not shown), an external selector may be disposed that interfaces with the sleeve 210 interior of the mechanism. The selector allows the user to choose a desired wire 102 length to be dispensed. The movement of the selector may move a stop that prevents motion of the sleeve or alternatively the selector may shorten the distance of the spring by compressing it. Both options will shorten the distance the sleeve can travel between the first and second positions.

The movement of the sleeve 210 and the three-jaw chuck 202 may be actuated by a pneumatic or other suitable drive system. The actuation of the system can be controlled by a controller that triggers the advancement and retraction of the mechanism 200. The controller can be triggered to dispense the wire 102 automatically or manually by a user.

In the embodiment shown in FIG 2A, the wire 102 is dispensed through the mechanism 200 from a spool 220. In some embodiments, the wire 102 is dispensed using a mechanical and/or electrical controller that feeds the wire. For example, the controller may include a mechanical or electrical pedal may be used to control the wire feed mechanism. As wire is advanced through the mechanism 200, it unwinds from the spool 220 which acts as a wire 102 reservoir. The spool is located in a cartridge 222 that is removable from the system allowing the user to insert a new cartridge 222 that has more wire 102 or wire having different properties. The ability to swap out different cartridges allows the user to change the wire easily and/or switch to a wire having different properties or composition for different tasks.

In an embodiment, the spool 220 may be created by axially winding the feed wire to create a center-pull spool 220. In this embodiment, there is no extraneous structure to the spool, the wire 102 itself forms the spool 220. The wire 102 is unwound from the spool 220 from the center, thus maintaining the structure of the spool 220 as the wire 102 is used.

The cartridge 222 and/or spool 220 may have a sensor or sensor system (not shown) that senses the amount of wire remaining on the spool 220. An indicator, such as an electronic LED or LCD indicator or a physical indicator or gauge, may interface with the sensor or sensor system and be used to display the condition and/or the amount of wire remaining on the spool 220. The sensor and display can display or indicate the amount of wire on the spool and/or provide an indication that the wire is about the run out.

Additionally, the mechanism 200 may feature a sensor or sensor system (not shown) that monitors the condition of the wire 102 as it passes through the device. The sensor or sensor system may be configured to monitor a number of wire conditions. Such conditions may include an "out-of-wire" or "out-of-alignment" condition. An "out-of-wire" condition may occur when the wire 102 has run out and/or is no longer capable of being advanced through the mechanism 200. An "out-of-alignment" condition may occur if the wire 102 miss-feeds through the device and is not engaged properly by the mechanism 200. The sensor or sensor system can communicate with the controller to control actuation of the mechanism 200 in a feedback configuration.

### WIRE HEATER

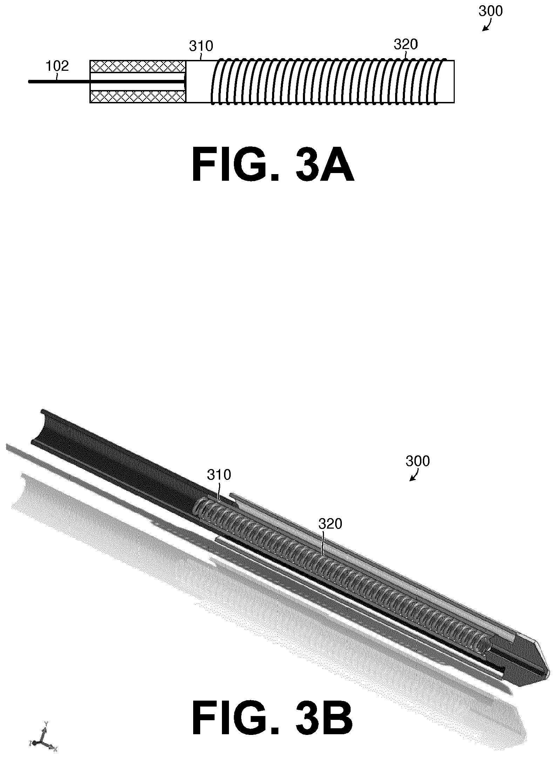

The wire heater 300, shown in FIG. 3A, heats the wire 102 as it is fed through the device 100. In the embodiment shown, the heater 300 includes a tube 310 and a heating element 320. The tube 310 is constructed of a thermally conductive material. The heating element 320 surrounds and heats the tube 310. In the embodiment shown, the heating element 320 may be a resistance wire that is wound around the tube 310. For example, the resistance wire may be a Nickel Chromium (Ni-Chrome) wire or any other type of that heats when current is applied to the wire. A power supply, not shown, energizes the Ni-Chrome wire heating element 320, causing the heating element to become hot. The thermal energy from the heating element 320 heats the tube 310. As the wire 102 advances through the tube 310, the wire 102 is heated to a sufficient temperature to be used in a soldering process. The wire 102, now heated, melts dispensed solder paste and solders the wire 102 to a user selected location.

The use of the wire 102 as a soldering tip for the device 100 ensures that the user is using a consistently new soldering tip. By soldering the exposed tip of the wire 102 to a desired location, and then advancing and trimming the wire to a desired length, a clean soldering tip is created.

In another embodiment, not shown, the tube 310 can have holes disposed about its length through which the heating element, Ni-Chrome wire, 320 passes through. Weaving the heating element through the tube 310 may heat the tube faster and more efficiently.

The energy flowing from the power supply into the heating element 320 can be adjusted by the user. Adjusting the power supply varies the temperature of the heating element 320. The Ni-Chrome wire used in the embodiment shown in FIG. 3 has thermal properties that correlate with the inputted energy. Therefore, by varying the power supply, the user can effectively set the temperature of the heating element 320 and the wire 102 as it is advanced through the heater 300. That is, the power supply provides enough energy to the heating element 320 to heat the wire 102 to a desired temperature that will melt the solder.

In yet another embodiment, shown in FIG. 3B, the heater 300 may include a pump that pumps air through the tube 310. Rather than only heating the wire 102, as discussed above, the heating element 320 heats the air pumped through the tube 310. The tube 310 can be profiled to concentrate and direct the flow of air exiting the tube 310. This allows the user to concentrate the flow of heated air to a specific point. The heated air melts the dispensed solder, allowing the wire 102 to be soldered or affixed to a desired location on a surface. As discussed above, the heating element 320 can be a Ni-Chrome wire, thus allowing the user to adjust the temperature of the heated air by varying the energy to the heating element 320, through a power supply.

Alternatively, the tube 310 may be a solid element having a tip that extends from the device 100 or a cartridge or tip can be inserted or affixed to the standard tube. Since a solid structure extends from the tube 310, the wire 102 cannot be fed through the device. In this embodiment, the device 100 effectively becomes a soldering iron, where the heating element 320 and tube 310 heat a tip that can be used to solder items or components as desired by the user. The use of the Ni-Chrome wire and variable power supply allows the user to control the temperature to which the soldering tip is heated.

### AIR HANDLING SYSTEM

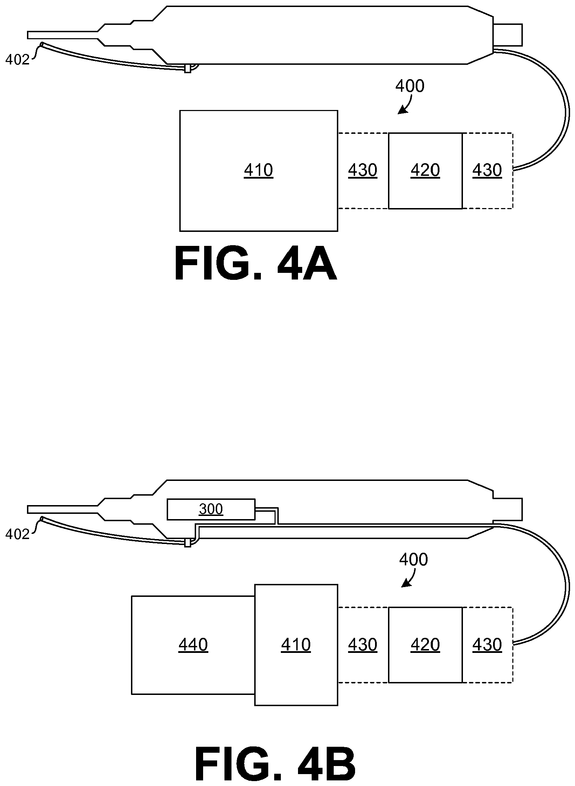

In some embodiments, the device 100 may include an air handling system 400, as shown in FIG. 4A. The air handling system 400 has an intake 402 located near the soldering tip of the device 100. A vacuum pump 410 is connected to the intake and is triggered by a controller 420 or a user. The vacuum pump 410 draws air through the intake 402 and away from the soldering point. Drawing fumes and smoke away from the soldering point protects the user's health and allows for greater site visibility. The air evacuated from the soldering point is passed through a filter 430 to trap any contaminants and pollutants. The contaminants and pollutants can be recovered from the filter for recycling or reuse. The cleaned air is then discharged into the surrounding environment.

### AIR RECIRCULATION SYSTEM

In some embodiments, the air handling system 400 and the wire heater 300, of the device 100, may be integrated as shown in FIG. 4B. In the integrated form, the air removed from the solder point is filtered and then stored in a reservoir 440. Air is drawn from the reservoir 440 for use in the wire heater 300. The air drawn from the reservoir can be mixed with environmental air or gas sources depending on soldering needs and requirements. The air handling system 400 may be controlled by a controller that controls the vacuum of air, the mix of air and the introduction of air through the wire heater 300.

### CAMERA AND LIGHTS

A camera 500 may be mounted on the device 100, as shown in FIG. 1. Images from the camera 500 are transmitted to a display or virtual reality glasses for viewing. The camera 500 may be connected to the display through a wired or wireless connection. The camera 500 provides a magnified view of the work area to assist the user with placement of the wire and soldering accuracy. In the embodiment shown, the camera 500 is located near the soldering tip; alternatively, the camera may be placed anywhere on the device 100 and focused on the work field. The camera 500 has a resolution and field of view sufficient for a user performing the soldering task. In another embodiment, the camera may be removable, allowing for the device to be used absent the camera or use of an alternative camera. An alternative camera may have different properties that are more desirable by a user for certain tasks. Such properties can include the viewable wavelength, field of view and magnification. The camera feed may be sent to a monitor that is positioned so a user or operator's posture is in a neutral position and not bent over, such as when using a microscope.

A light system 510 may also be disposed on the device 100, as shown in FIG. 1. The light system 510 provides light for the camera 500 and illuminates the field for the user. In the embodiment shown in FIG. 1, the light system 510 comprises high discharge light-emitting diodes (LEDs) that are aimed at the same focal point as the camera 500. In an embodiment, the LEDs of the light system 510 can be adjustable by the user. Such adjustments can include the focal point of the light and intensity of light and the number and arrangement of the LEDs. In another embodiment, another suitable light source may be used in place of the LEDs; the replacement source should have similar compact overall package and sufficient light emission to illuminate the working field.

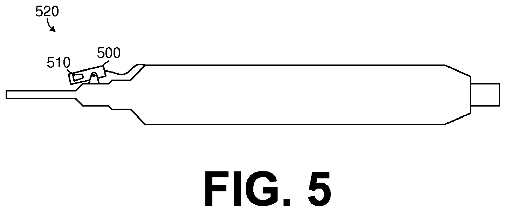

In another embodiment, the camera 500 and light system 510 may be integrated into a package 520, as shown in FIG. 5. The combined light and camera package 520 is mounted on the device 100 to illuminate the working field and relay images of the field to an external display viewable by a device user. An example of an integrated light and camera package 520 is a fiberscope. The fiberscope includes two optical fiber sets, a first set transmits light and a second set receives light. Light is transmitted from a source, external or mounted on the device, through the first set of optical fibers and illuminates the work field. The second set of optical fibers receives light reflected from the field; the reflected light is then displayed as an image for the user.

Images displayed from the camera system may also be recorded or captured for quality control or other purposes.

### SOLDER DISPENSER

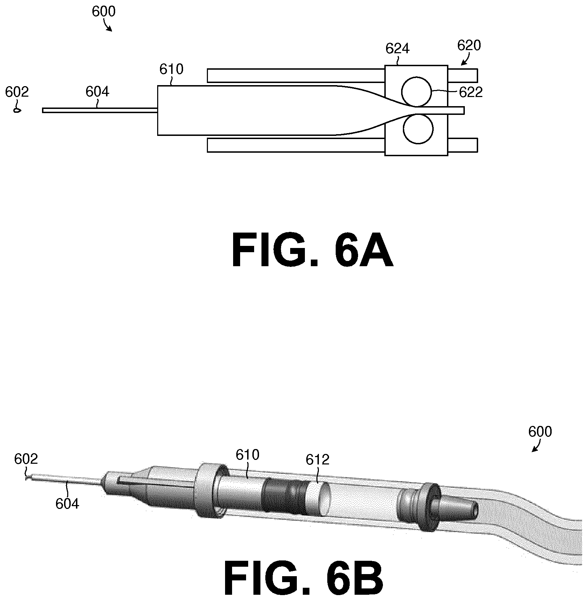

A solder dispensing system 600, shown in FIG. 6A, may be disposed on the device 100 of FIG. 1. However, as mentioned above, the user may also manually add solder paste to the tip of the wire 102 or to the surface the wire 102 is to be soldered on. The dispenser 600 dispenses a solder paste 602 at the point of soldering. In the embodiment shown, the solder dispensing system consists of a tube 610 containing solder paste 602, a dispensing mechanism 620 and an output 604. The solder paste 602 is contained in a tube 610 that is mounted into the system 600. The dispensing mechanism 620 consists of a pinch mechanism 622 and a twin-roller crawler 624. To dispense the paste 602, the pinch mechanism 622 squeezes the tube 610, forcing the solder paste 602 to be dispensed through the output 604. The twin-roller crawler 624 advances the pinch mechanism 622 along the length of the tube. Advancement of the pinch mechanism 622 along the tube length ensures that solder paste is consistently delivered from the output 604.

In an alternative embodiment, shown in FIG. 6B, the solder dispensing system 600 is a pneumatic powered dispenser. The solder paste 602 is contained in a tube 610 and a plunger 612 is disposed at an end of the tube. Pneumatic pressure on the plunger 612 causes the plunger to advance through the tube 610, forcing solder paste 602 through the output 604. The pneumatic pressure used to move the plunger 612 can come from a source external from the device. In an embodiment, the pneumatic pressure can be supplied from the air handling system.

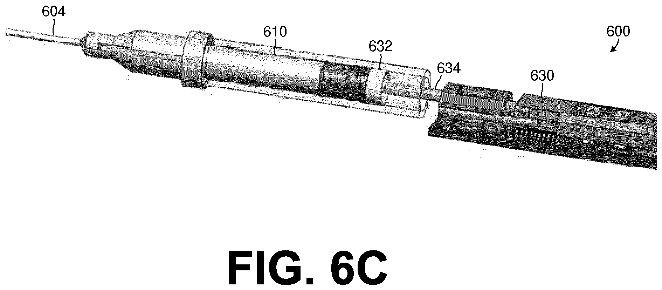

In yet another embodiment, shown in FIG. 6C, the solder dispensing system 600 uses a linear motor 630. The linear motor 630 features a shaft 634 that is connected to a plunger 632. The plunger 632 interfaces with the solder paste tube 610 to force solder paste 602 through the output 604 as the plunger 632 is advanced by the shaft 634. The linear motor 630 can be a piezo-electric motor capable of incremented known extension lengths.

The amount of solder paste 602 dispensed through the output 604 may be controlled by a controller. The controller communicates with any of the embodiments discussed above to dispense a desired amount of solder paste. A user can control the amount of solder dispensed by dispensing a pre-set amount with each cycle or may have active control through the use of a button or other means. The active control allows the user to dispense any amount of solder as desired. Additionally, the system 600 and device 100 may include a sensor or sensor system (not shown) that provide feedback information to the controller to control the amount of solder paste dispensed. The sensor or sensor system may monitor such conditions as the amount of solder paste remaining, the amount of solder paste dispensed and the type and size of the wire 102, among others. The controller can process the sensor inputs to calculate a proper amount of solder paste to dispense and/or provide the user indications of the state of the solder paste, the amount of solder paste dispensed and the amount of solder paste to dispense.

In the embodiments described above, the solder paste 602 is contained in a tube 610 that may be removable and replaceable in the device 100. This allows the user to quickly and easily change the type of solder paste and to replace the tube 610 if the paste runs out.

### WIRE CUTTER

The device 100 of FIG. 1 may include a wire cutter 700, in some embodiments. The wire cutter 700 severs the wire 102 from the device 100. The wire cutter 700 is disposed near the soldering tip and severs the wire 102 on actuation by the user. The wire cutter 700 can be a mechanism suitable of severing the wire; such mechanisms include a user-actuated wire cutter, a pneumatically actuated wire cutter, and an electrically-actuated wire cutter.

### SOLDER JOINT COOLING SYSTEM

In some embodiments, a solder joint cooling system 800 may be disposed on the device 100, as shown in FIG. 1. The cooling system 800 features an outlet 802 located near the soldering end of the device 100. The cooling system 800 dispenses a forced air blast that assists in setting the solder. Air used in the system 800 may be compressed environmental air, air from the air handling reservoir, or other sources. A user actuates a release mechanism that causes a blast of compressed air to be dispensed through the outlet 802. The rush of air across the hot solder cools and solidifies the solder.

Examples provide a hand-held soldering device, comprising a wire feeder configured to advance a wire to a tip of the soldering device and a heater configured to heat the wire as a soldering tip to attach the wire to a surface with solder during a soldering process.

In some examples, the heater includes a tube, a heating element in direct contact with the tube, and a power supply connected to the heating element, and the wire feeder is further configured to advance the wire to the tip of the soldering device through the tube.

In some examples, the heating element is a nickel chromium wire.

In some examples, the tube comprises a thermally conductive material.

In some examples, the soldering device further comprises an air recirculation system configured to collect air generated during the soldering process.

In some examples, the air recirculation system includes a filter, a bladder, and a vacuum configured to draw air from the tip of the soldering device through the filter into the bladder during the soldering process.

In some examples, the wire feeder includes a cartridge containing a spool of wire.

In some examples, the wire feeder includes a wire feed drive system connected to the cartridge containing the spool of wire, and a controller configured to operate the wire feed drive system.

In some examples, the controller is a mechanical controller.

In some examples, the wire feed drive system includes a pneumatically driven plunger and pinch mechanism.

In some examples, the soldering device includes an indicator configured to indicate when the cartridge is empty.

In some examples, the wire feeder further includes a sensor configured to sense an out-of-wire condition, and the controller is further configured to be deactivated in response to the sensed out-of-wire condition.

In some examples, the cartridge containing a spool of wire is removable.

In some examples, the soldering device further comprises a solder paste dispenser.

In some examples, the solder paste dispenser includes a cartridge containing solder, a solder paste feed system connected to the cartridge containing solder and configured to dispense solder from the cartridge containing solder, and a controller configured to operate the solder paste feed system.

In some examples, the solder paste feed system is further configured to dispense solder to a point of soldering.

In some examples, the solder paste feed system comprises a piston configured to displace solder paste within the cartridge containing solder to output solder to the tip of the wire.

In some examples, the piston is pneumatically driven.

In some examples, the piston is electrically driven.

In some examples, the cartridge containing the solder paste is removable.

In some examples, the soldering device further comprises a camera. In some examples, the soldering device further comprises an illumination device.

In some examples, the soldering device further comprises a cutter configured to cut the wire after the wire has been attached to the surface during the soldering process.

In some examples, the soldering device further comprises a cooling system configured to output cool air to solidify the wire and the solder to the surface.

Having described and illustrated the principles of the disclosed technology in a preferred embodiment thereof, it should be apparent that the disclosed technology can be modified in arrangement and detail without departing from such principles. We claim all modifications and variations coming within the scope of the following claims.

## Claims

1. A hand-held soldering device (100), comprising:
a tip;
a wire feeder (200) configured to advance a wire (102) through the tip of the soldering device (100); and
a heater (300) configured to heat the wire (102); and **characterised by** :
means for supplying solder to a soldering location;
wherein, in use, the tip of the wire (102) is heated, by the heater (300), to act as a soldering iron tip during a soldering process.

2. The soldering device (100) of claim 1 in which
the heater (300) includes:
a tube (310),
a heating element (320) in direct contact with the tube (310), and
a power supply connected to the heating element (320); and
the wire feeder (200) is further configured to advance the wire (102) through the tip of the soldering device through the tube (310).

3. The soldering device (100) of claim 1 or 2, further comprising an air recirculation system (400) configured to collect fumes generated during the soldering process.

4. The soldering device (100) of claim 3 in which the air recirculation system (400) includes:
a filter (430),
a bladder, and
a vacuum device (410) configured to draw air from the tip of the soldering device (100) through the filter (430) into the bladder during the soldering process.

5. The soldering device (100) of any preceding claim in which the wire feeder (200) includes a cartridge (222) containing a spool of wire (220).

6. The soldering device (100) of claim 5 in which the wire feeder (200) includes:
a wire feed drive system connected to the cartridge containing the spool of wire, and
a controller configured to operate the wire feed drive system.

7. The soldering device (100) of claim 6 in which the controller is a mechanical controller.

8. The soldering device (100) of claim 6 or 7 in which the wire feed drive system includes a pneumatically driven plunger and pinch mechanism.

9. The soldering device (100) of any of claims 5 to 8 in which the soldering device (100) includes an indicator configured to indicate when the cartridge (222) is empty.

10. The soldering device (100) of any of claims 5 to 8 in which the wire feeder (200) further includes a sensor configured to sense an out-of-wire condition, and the controller is further configured to be deactivated in response to the sensed out-of-wire condition.

11. The soldering device (100) of any preceding claim further comprising a camera (500).

12. The soldering device (100) of any preceding claim further comprising an illumination device (510).

13. The soldering device (100) of any preceding claim further comprising a cutter (700) configured to cut the wire (102) after the soldering process.

14. The soldering device (100) of any preceding claim further comprising a cooling system (800) configured to output cool air at the tip of the soldering device (100) to solidify solder.

15. A method of soldering with a hand-held soldering device (100), comprising:
feeding wire (102) through a tip of the hand-held soldering device (100);
heating the wire (102) to a desired temperature;
and **characterised by** :
supplying solder to a soldering location; and
soldering using the wire (102) as a soldering iron tip when the wire (102) is heated to the desired temperature and the solder is supplied to the soldering location.

## Patentansprüche

1. Handlötvorrichtung (100), umfassend:
eine Spitze;
einen Drahtförderer (200), der konfiguriert ist, um einen Draht (102) durch die Spitze der Lötvorrichtung (100) vorwärts zu bewegen; und
eine Heizung (300), die konfiguriert ist, um den Draht (102) zu erhitzen; und durch folgendes gekennzeichnet ist:
Mittel zum Zuführen von Lot zu einer Lötstelle;
wobei die Spitze des Drahts (102) in der Verwendung durch die Heizung (300) erhitzt wird, um während eines Lötvorgangs als eine Lötkolbenspitze zu wirken.

2. Lötvorrichtung (100) nach Anspruch 1, wobei die Heizung (300) folgendes enthält:
eine Röhre (310),
ein Heizelement (320) in direktem Kontakt mit der Röhre (310), und
eine Stromversorgung, die mit dem Heizelement (320) verbunden ist; und der Drahtförderer (200) ferner konfiguriert ist, um den Draht (102) durch die Spitze der Lötvorrichtung durch die Röhre (310) vorwärts zu bewegen.

3. Lötvorrichtung (100) nach Anspruch 1 oder 2, ferner umfassend ein Luftumwälzungsystem (400), das konfiguriert ist, um während des Lötvorgangs erzeugten Rauch zu sammeln.

4. Lötvorrichtung (100) nach Anspruch 3, wobei das Luftumwälzungsystem (400) folgendes enthält:
einen Filter (430),
einen Balg, und
eine Vakuumvorrichtung (410), die konfiguriert ist, um während des Lötvorgangs Luft von der Spitze der Lötvorrichtung (100) durch den Filter (430) in den Balg anzusaugen.

5. Lötvorrichtung (100) nach einem vorherigen Anspruch, wobei der Drahtförderer (200) eine Kartusche (222) enthält, die eine Drahtspule (220) beinhaltet.

6. Lötvorrichtung (100) nach Anspruch 5, wobei der Drahtförderer (200) folgendes enthält:
ein Drahtförderung-Antriebssystem, das mit der Kartusche verbunden ist, die die Drahtspule beinhaltet, und
einen Regler, der konfiguriert ist, um das Drahtförderung-Antriebssystem zu betreiben.

7. Lötvorrichtung (100) nach Anspruch 6, wobei der Regler ein mechanischer Regler ist.

8. Lötvorrichtung (100) nach Anspruch 6 oder 7, wobei das Drahtförderung-Antriebssystem einen pneumatisch angetriebenen Kolben- und Einklemmmechanismus enthält.

9. Lötvorrichtung (100) nach einem der Ansprüche 5 bis 8, wobei die Lötvorrichtung (100) eine Anzeige enthält, die konfiguriert ist, um anzuzeigen, wenn die Kartusche (222) leer ist.

10. Lötvorrichtung (100) nach einem der Ansprüche 5 bis 8, wobei der Drahtförderer (200) ferner einen Sensor enthält, der konfiguriert ist, um einen Zustand ohne Draht zu erfassen, und der Regler ferner konfiguriert ist, um als Reaktion auf den erfassten Zustand ohne Draht deaktiviert zu werden.

11. Lötvorrichtung (100) nach einem vorherigen Anspruch, ferner umfassend eine Kamera (500).

12. Lötvorrichtung (100) nach einem vorherigen Anspruch, ferner umfassend eine Beleuchtungsvorrichtung (510).

13. Lötvorrichtung (100) nach einem vorherigen Anspruch, ferner umfassend eine Schneideeinrichtung (700), die konfiguriert ist, um den Draht (102) nach dem Lötvorgang zu schneiden.

14. Lötvorrichtung (100) nach einem vorherigen Anspruch, ferner umfassend ein Kühlsystem (800), das konfiguriert ist, um kalte Luft an der Spitze der Lötvorrichtung (100) auszugeben, um das Lot zu verfestigen.

15. Lötverfahren mit einer Handlötvorrichtung (100), umfassend:
Fördern von Draht (102) durch eine Spitze der Handlötvorrichtung (100);
Erhitzen des Drahts (102) auf eine gewünschte Temperatur;
und **gekennzeichnet durch** folgendes:
Zuführen von Lot zu einer Lötstelle; und
Löten unter Verwendung des Drahts (102) als eine Lötkolbenspitze, wenn der Draht (102) auf die gewünschte Temperatur erhitzt ist und das Lot zu der Lötstelle zugeführt wird.

## Revendications

1. Appareil de soudure portatif (100), comprenant :
une extrémité ;
un dévidoir (200) configuré pour faire avancer un fil (102) à travers l'extrémité de l'appareil de soudure (100) ; et
un système chauffant (300) configuré pour chauffer le fil (102) ; et **caractérisé par** :
un moyen d'amenée de brasure à un emplacement de soudure ; dans lequel, en utilisation, l'extrémité du fil (102) est chauffée, par le système chauffant (300), pour faire office de panne de poste à souder pendant le le processus de soudure.

2. Appareil de soudure (100) selon la revendication 1, dans lequel le système chauffant (300) inclut :
un tube (310),
un élément chauffant (320) en contact direct avec le tube (310), et
une alimentation connectée à l'élément chauffant (320) ; et
le dévidoir (200) est en outre configuré pour faire avancer le fil (102) à travers l'extrémité de l'appareil de soudure à travers le tube (310).

3. Appareil de soudure (100) selon la revendication 1 ou 2, comprenant en outre un système de recicurlation d'air (400) configuré pour collecter des fumées générées pendant le processus de soudure.

4. Appareil de soudure (100) selon la revendication 3, dans lequel le système de recirculation d'air (400) inclut :
un filtre (430),
une vessie et
un dispositif de vide (410) configuré pour aspirer l'air en provenance de l'extrémité de l'appareil de soudure (100) à travers le filtre (430) dans la vessie pendant le processus de soudure.

5. Appareil de soudure (100) selon l'une quelconque des revendications précédentes, dans lequel le dévidoir (200) inclut une cartouche (222) contenant une bobine de fil (220).

6. Appareil de soudure (100) selon la revendication 5, dans lequel le dévidoir (200) inclut :
un système d'entraînement de délivrance de fil raccordé à la cartouche contenant la bobine de fil, et une unité de commande configurée pour faire fonctionner le système d'entraînement de délivrance de fil.

7. Appareil de soudure (100) selon la revendication 6, dans lequel l'unité de commande est une unité de commande mécanique.

8. Appareil de soudure (100) selon la revendication 6 ou 7, dans lequel le système d'entraînement de délivrance de fil inclut un piston à entraînement pneumatique et un mécanisme de pincement.

9. Appareil de soudure (100) selon l'une quelconque des revendications 5 à 8, dans lequel l'appareil de soudure (100) inclut un indicateur configuré pour indiquer quand la cartouche (222) est vide.

10. Appareil de soudure (100) selon l'une quelconque des revendications 5 à 8, dans lequel le dévidoir (200) inclut en outre un capteur configuré pour détecter une condition de fin du fil, et l'unité de commande est en outre configurée pour être désactivée en réponse à la condition de fin du fil.

11. Appareil de soudure (100) selon l'une quelconque des revendications précédentes, comprenant en outre une caméra (500).

12. Appareil de soudure (100) selon l'une quelconque des revendications précédentes, comprenant en outre un système d'éclairage (510).

13. Appareil de soudure (100) selon l'une quelconque des revendications précédentes, comprenant en outre un outil de coupe (700) configuré pour couper le fil (102) après le processus de soudure.

14. Appareil de soudure (100) selon l'une quelconque des revendications précédentes, comprenant en outre un système de refroidissement (800) configuré pour diffuser de l'air froid au niveau de l'extrémité de l'appareil de soudure (100) pour solidifier la brasure.

15. Procédé de soudure avec un appareil de soudure portatif (100), comprenant :
la délivrance d'un fil (102) à travers une extrémité de l'appareil de soudure portatif (100) ;
le chauffage du fil (102) à une température souhaitée ; et **caractérisé par** :
l'amenée de brasure à un emplacement de soudure ; et
la soudure en utilisant le fil (102) comme une panne de fer à souder quand le fil (102) est chauffé à la température souhaitée et la soudure est amenée à l'emplacement de soudure.
